(19)

Europäisches
Patentamt
European
Patent Office
Office européen
des brevets

(11) **EP 2 135 978 A1**

(12) **EUROPEAN PATENT APPLICATION**
published in accordance with Art. 153(4) EPC

(43) Date of publication:
**23.12.2009 Bulletin 2009/52**

(51) Int Cl.:
*C30B 29/22* (2006.01)    *C30B 19/02* (2006.01)
*H01L 21/368* (2006.01)    *H01L 33/00* (2006.01)

(21) Application number: **08722549.6**

(22) Date of filing: **14.03.2008**

(86) International application number:
**PCT/JP2008/055179**

(87) International publication number:
**WO 2008/114845 (25.09.2008 Gazette 2008/39)**

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **20.03.2007 JP 2007072954**

(71) Applicants:
• **Mitsubishi Gas Chemical Company, Inc.
  Tokyo 100-8324 (JP)**
• **National Institute for Materials Science
  Tsukuba-shi, Ibaraki 305-0047 (JP)**

(72) Inventors:
• **SEKIWA, Hideyuki
  Tokyo 125-0051 (JP)**

• **KOBAYASHI, Jun
  Tokyo 125-0051 (JP)**
• **OHASHI, Naoki
  Tsukuba-shi
  Ibaraki 305-0047 (JP)**
• **SAKAGUCHI, Isao
  Tsukuba-shi
  Ibaraki 305-0047 (JP)**

(74) Representative: **Maiwald Patentanwalts GmbH
Elisenhof
Elisenstrasse 3
80335 München (DE)**

(54) **Mg-CONTAINING ZnO MIXED SINGLE CRYSTAL, LAMINATE THEREOF AND THEIR PRODUCTION METHODS**

(57)    The present invention can provide an Mg-containing ZnO mixed single crystal wherein the mixed single crystal comprises an Mg-containing ZnO semiconductor having a bandgap (Eg) of $3.30 < Eg \leq 3.54$ eV, and has a film thickness of 5 $\mu$m or less. The present invention can provide a method for producing an Mg-containing ZnO mixed single crystal by liquid phase epitaxial growth, wherein the method comprises: mixing and melting ZnO and MgO as solutes and PbO and $Bi_2O_3$ (or $PbF_2$ and PbO) as solvents; and putting a substrate into direct contact with the obtained melt solution, thereby growing the Mg-containing ZnO mixed single crystal on the substrate.

Fig. 2

**Description**

TECHNICAL FIELD

The present invention relates to a ZnO-based semiconductor material. Particularly, the present invention relates to an Mg-containing ZnO mixed single crystal having a bandgap useful in an optical field, and electrical and electronic industrial fields, a laminate thereof, and methods for producing the same.

BACKGROUND ART

Si, GaAs and GaN or the like have been used for optical and electronic devices having various functions. Recently, light emitting devices and electronic devices using GaN have been actively developed. On the other hand, in focusing attention on oxides, ZnO, which has been used for varistors, gas sensors, sunscreens or the like, has recently been a target of attention as being applied to optical elements, electronic elements, piezoelectric elements and transparent electrodes or the like owing to optical characteristics, electronic element characteristics and piezoelectric characteristics thereof. Especially, research and development activities are now eagerly conducted to apply ZnO for semiconductors used for light emitting elements which emit light of a short wavelength in the blue to ultraviolet range and applications thereof since it is known that ZnO has a direct bandgap of 3.3 to 3.4 eV like GaN and radiates ultraviolet rays of 380 nm.

A modulation doping technique exists as one of methods for contacting semiconductors with each other in a state where an electrical field is not applied unlike a filed-effect transistor in a ZnO-based semiconductor single crystal laminate to produce charge separation. For example, Japanese Patent Application Laid-Open No. 2005-72067 discloses a semiconductor material obtained by laminating a semiconductor having a wide bandgap and having high electronic concentration and a semiconductor having a narrow bandgap and having high electronic mobility. In the semiconductor material, charge transfer is induced to the semiconductor having high electronic mobility from the semiconductor having high electronic concentration, and electrons pass through a layer having high mobility to satisfy both the high electronic concentration and the high electronic mobility.

Furthermore, in order to produce an ultraviolet light emitting device using ZnO, it is shown that $Zn_{1-x}Mg_xO$ of a group-II-VI semiconductor mixed crystal having a wide bandgap is obtained at the growth temperature of 600°C by a pulsed laser depositing technique, and a wider bandgap than that of ZnO is obtained by adjusting a composition x (A. Ohtomo et. al, Applied Physics Letters, Vol. 72, No. 19, 11 May 1998, 2466 to 2468). When the application to the light emitting elements is considered, it is necessary to adopt a double heterostructure in order to enhance light emitting efficiency. The confinement efficiency of carrier and light is enhanced by adopting the above-mentioned structure to enhance the light emitting efficiency. In order to form the above-mentioned structure, a light emitting layer is required to be sandwiched between n and p layers having a high bandgap. Accordingly, a ZnO-based mixed single crystal having a higher bandgap than that of ZnO is required.

High crystallinity is required in order to exhibit the original electronic element characteristics and optical element characteristics of the ZnO-based semiconductor single crystal and laminate thereof. The ZnO-based semiconductor single crystal has been conventionally grown by a vapor phase growth technique using an insulative substrate made of ZnO, $ScAlMgO_4$ and sapphire or the like. In order to achieve the high crystallinity, a substrate having small lattice mismatch is required to be used. Therefore, a ZnO single crystal is desirably used as the substrate. However, since a commercially available ZnO single crystal substrate is grown by a hydrothermal technique, the ZnO single crystal substrate cannot avoid the mixing of Li based on LiOH used as a mineralizer into the ZnO single crystal. The ZnO single crystal substrate has a problem that Li in ZnO is easily diffused and Li moves in operating the device to make the device operation unstable. If the ZnO-based semiconductor single crystal having a thick film thickness and the laminate thereof can be grown, the influence of Li diffusion from the substrate can be reduced. Unduly large amount of lattice mismatch occurs between the ZnO substrate and the growing ZnO-based mixed crystal film. However, thick film growth is required even in respect of relieving strain. However, in vapor phase epitaxy, the growth rate is low, and thick film growth is very difficult. On the other hand; in the liquid phase growth technique, the growth rate can be controlled by controlling the degree of supersaturation to enable a relatively high growth rate.

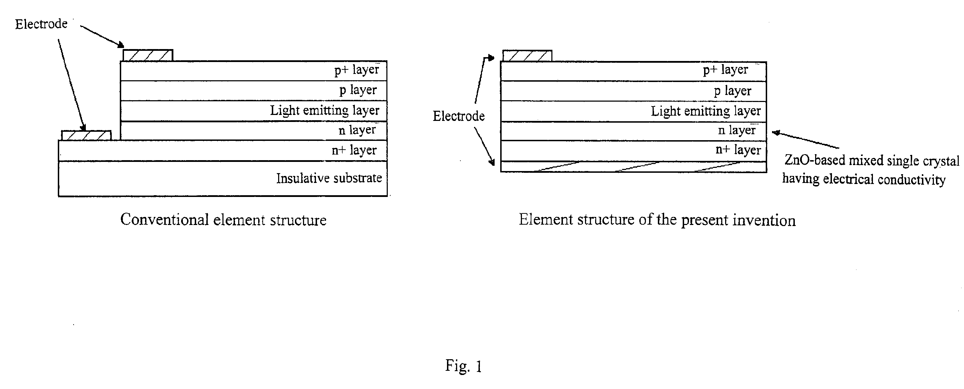

As described above, in the vapor phase epitaxy and the liquid phase growth, an insulative material is often used for the substrate. Therefore, in order to form the electronic elements and optical elements using the ZnO-based mixed single crystal, artifices such as the formation of an electrode in the same direction are required. This technique has problems that the production processes of the electronic elements or optical elements are complicated, which causes high cost of production and concentrates an electrical field on a part of an (n+) layer of an n type contact layer to shorten the element life. However, if the ZnO film and ZnO-based mixed crystal film having electrical conductivity using the insulative substrate can be thickly grown and the unnecessary insulative substrate can be removed by polishing or the like, electrodes can be formed on the front and rear surfaces and the enhancement in performance can be expected even in respects of the device characteristics or life even in the production process of the device (see Figure 1).

Furthermore, the ZnO-based semiconductor single crystal and the laminate thereof as research of the above-mentioned material are grown by the vapor phase growth technique which is non-thermal equilibrium growth (for example, Japanese Patent Application Laid-Open No. 2003-046081). The single crystal and the laminate cannot avoid the mixing of non-thermal equilibrium growth defects, and it cannot be said that the quality of the resultant crystals is insufficient. The crystallinities of a filed-effect transistor and pn junction light emitting element or the like as an example of a conventional semiconductor element is greatly involved in optical characteristics or semiconductor characteristics. Since the crystal quality of the crystals obtained by the vapor phase growth technique is insufficient as described above, the vapor phase growth technique has a problem that the original performance cannot be sufficiently exhibited. Therefore, in order to apply and develop the ZnO-based mixed single crystal and the laminate thereof to the above-mentioned application or the like, it becomes an important problem to establish methods for producing the ZnO-based mixed single crystal having high crystal quality and the laminate.

As the methods for growing the ZnO-based semiconductor single crystal and the laminate thereof, a sputtering technique, a CVD technique and a PLD technique or the like have been conventionally used. In these methods, the growth direction of a ZnO-based semiconductor layer is a -(c) face direction. The methods have a problem that it is difficult to take in an acceptor in -(c) face growth (Maki et al. Jpn. J. Appl. Phys. 42 (2003) 75 to 77). In the case of the ZnO-based semiconductor layer, n type growth is comparatively easy. However, in consideration of difficult p type growth, the -(c) face growth has a problem that it becomes difficult to further grow a p type layer. Since the - (c) face growth film is an oxygen face, the -(c) face growth film has problems that an etching rate caused by acid, which is quick, is difficult to be controlled and etching having high planarity is difficult.

DISCLOSURE OF THE INVENTION

As described above, there are problems of the diffusion of impurities into the growth film from the substrate used when the ZnO-based semiconductor single crystal and the laminate thereof are grown and the generation of the strain caused by the lattice mismatch between the substrate and the growth film. There are problems that electrodes cannot be formed on the front and the surfaces in forming the device; the production cost is high; and the element life is shortened since the substrate when the ZnO-based semiconductor single crystal and the laminate thereof are grown is insulative. Furthermore, the ZnO-based semiconductor single crystal and the laminate thereof, which are grown by the vapor phase growth technique as non-thermal equilibrium growth, have nonequilibrium defects and cannot exhibit the original characteristics of the ZnO-based semiconductor single crystal and laminate thereof. Since the ZnO-based semiconductor single crystal and the laminate thereof are grown in the -(c) face direction, there are problems that the ZnO-based semiconductor single crystal and the laminate are easily grown like an island; the p type growth is difficult; the etching rate in forming the device is difficult to be controlled; and the planarity is low. It is an object of the present invention to solve these problems.

The above-mentioned problems can be solved by the following present invention. A first embodiment of the present invention is an Mg-containing ZnO mixed single crystal **characterized in that** the mixed single crystal includes an Mg-containing ZnO semiconductor having a bandgap (Eg) of $3.30 < Eg \leq 3.54$ eV, and has a film thickness of 5 $\mu$m or more. This single crystal has a composition represented by $Zn_{1-x}Mg_xO$. The preferable aspect of the present invention is the above-mentioned Mg-containing ZnO mixed single crystal further including one or more selected from the group consisting of Al, Ga, In, H and F. Another preferable aspect of the present invention is the above-mentioned Mg-containing ZnO mixed single crystal, wherein a growth direction is a +(c) face direction.

A second embodiment of the present invention is an Mg-containing ZnO mixed single crystal laminate including a plurality of layers including an Mg-containing ZnO semiconductor having a bandgap (Eg) of $3.30 < Eg \leq 3.54$ eV, **characterized in that** the first layer is a growth layer having a film thickness of 5 $\mu$m or more. The preferable aspect of the present invention is the above-mentioned Mg-containing ZnO mixed single crystal laminate, wherein at least one layer of the plurality of layers contains one or more selected from the group consisting of Al, Ga, In, H and F. Another preferable aspect of the present invention is the above-mentioned Mg-containing ZnO mixed single crystal laminate, wherein a growth direction is a +(c) face direction.

A third embodiment of the present invention is a method for producing an Mg-containing ZnO mixed single crystal by liquid phase epitaxial growth, **characterized in that** the method includes: mixing and melting ZnO and MgO as solutes and PbO and $Bi_2O_3$ as solvents; and putting a substrate into direct contact with the obtained melt solution, thereby growing the Mg-containing ZnO mixed single crystal on the substrate. The preferable aspect of the present invention is the above-mentioned method for producing the Mg-containing ZnO mixed single crystal, wherein the mixing ratio of the solute with respect to the solvent is the solute expressed in terms of only ZnO:the solvent=5 to 30 mol%:95 to 70 mol%, and the mixing ratio of PbO and $Bi_2O_3$ as the solvents is $PbO:Bi_2O_3$=0.1 to 95 mol%:99.9 to 5 mol%. The Mg-containing ZnO mixed single crystal as the above-mentioned first embodiment of the present invention is suitably obtained by the method for producing the Mg-containing ZnO mixed single crystal as the third embodiment.

A fourth embodiment of the present invention a method for producing an Mg-containing ZnO mixed single crystal by liquid phase epitaxial growth, **characterized in that** the method includes: mixing and melting ZnO and MgO as solutes and $PbF_2$ and PbO as solvents; and putting a substrate into direct contact with the obtained melt solution, thereby growing the Mg-containing ZnO mixed single crystal on the substrate. The preferable aspect of the present invention is the above-mentioned method for producing the Mg-containing ZnO mixed single crystal, wherein the mixing ratio of the solute with respect to the solvent is the solute expressed in terms of only ZnO:the solvent=2 to 20 mol%:98 to 80 mol%, and the mixing ratio of $PbF_2$ and PbO as the solvents is $PbF_2$:PbO=80 to 20 mol%:20 to 80 mol%. The Mg-containing ZnO mixed single crystal as the above-mentioned first embodiment of the present invention is suitably obtained by the method for producing the Mg-containing ZnO mixed single crystal as the fourth embodiment.

Furthermore, the third and fourth embodiments of the present invention are also preferably the following aspects: an aspect in which the above-mentioned Mg-containing ZnO mixed single crystal includes a minute amount of other chemical elements; an aspect in which the minute amount of other chemical elements is 1 mol% or less of other chemical elements; an aspect in which the other chemical elements is one or more selected from the group consisting of Li, Na, K, Cs, Rb, Be, Ca, Sr, Ba, Cu, Ag, N, P, As, Sb, Bi, B, Tl, Cl, Br, I, Mn, Fe, Co, Ni, Ti, Cd, Zr, Hf, V, Nb, Ta, Cr, Mo, W and lanthanoid elements; an aspect in which a ZnO single crystal is used as the above-mentioned substrate; and an aspect in which the above-mentioned Mg-containing ZnO mixed single crystal is grown, and the substrate is then removed by polishing or etching.

A fifth embodiment of the present invention is a method for producing an Mg-containing ZnO mixed single crystal laminate, **characterized in that** the method includes: growing a first Mg-containing ZnO mixed single crystal by the method for producing the Mg-containing ZnO mixed single crystal described in the third or fourth embodiment; and further growing a second Mg-containing ZnO mixed single crystal on the first Mg-containing ZnO mixed single crystal used as a substrate. The Mg-containing ZnO mixed single crystal laminate as the above-mentioned second embodiment of the present invention is suitably obtained by the method for producing the Mg-containing ZnO mixed single crystal laminate as the fifth embodiment.

In this specification, the term "solute" refers to a substance which is dissolved in a solvent for forming a solution, and the term "solvent" refers to a substance acting as a medium for the substance to be dissolved for forming the solution.

The Mg-containing ZnO mixed single crystal of the present invention, which has high crystallinity, can control a carrier while highly holding mobility of carrier. Since the growth film thickness can be set to 5 μm or more, the diffusion of impurities from the substrate or the strain caused by the lattice mismatch can be relieved, and therefore, the Mg-containing ZnO mixed single crystal is usable for electronic elements and optical elements, which are expected to be developed in the future.

BRIEF DESCRIPTION OF THE DRAWINGS

Figure 1 shows structures showing a conventional element structure and an element structure using an Mg-containing ZnO mixed single crystal which is an example of the present invention; and
Figure 2 is a structure of a furnace used in Examples of the present invention and Comparative Examples.

BEST MODE FOR CARRYING OUT THE INVENTION

Hereinafter, the present invention will be further described in detail.

A first embodiment of the present invention is an Mg-containing ZnO mixed single crystal **characterized in that** the mixed single crystal includes an Mg-containing ZnO semiconductor having a bandgap (Eg) of $3.30 < Eg \leq 3.54$ eV, and has a film thickness of 5 μm or more. Since the above-mentioned ZnO-based mixed single crystal has the film thickness of 5 μm or more, the ZnO-based mixed single crystal can relieve diffusion of impurities from a substrate or strain caused by the lattice mismatch between the substrate and a growth film.

The control of the bandgap of the ZnO-based semiconductor can be achieved by changing ZnO and MgO or BeO into a mixed crystal. However, MgO is preferable in consideration of toxicity or the like. The bandgap of the ZnO-based mixed single crystal of 3.30 eV or less is not preferable because the mixed crystal rate of MgO is low. The bandgap of more than 3.54 eV is not preferable because an MgO single phase other than a ZnO-based mixed crystal is deposited.

The above-mentioned bandgap (Eg) can be obtained by measuring the PL light emitting wavelength of the Mg-containing ZnO mixed single crystal obtained in the present invention and using the following formula.

$$Eg \ [eV] = 1.24 / PL \ light \ emitting \ wavelength \ [nm] * 1000$$

A method for measuring the PL light emitting wavelength is not particularly limited. However, the present invention is based on a value measured at room temperature (300 K) using rpm2000 produced by Accent and a He-Cd laser ($\lambda$= 325 nm) as an excitation laser.

The preferable aspect of the present invention includes one or more selected from the group consisting of Al, Ga, In, H and F. The inclusion of one or more selected from the group consisting of Al, Ga, In, H and F can express electrical conductivity. If the substrate used in growth is removed by polishing and etching or the like, electrodes can be formed on the front and rear surfaces of an electronic element or optical element.

In the preferable aspect of the present invention, a growth direction is a +(c) face direction. A ZnO single crystal which is a hydrothermal synthesis substrate and has the growth direction of a +(c) face is used as the substrate, and thereby a ZnO-based semiconductor single crystal which easily takes in an acceptor without being grown like an island can be grown. Since the growth direction is the + (c) direction, the etching rate for forming a device is low, and thereby the planarity of an etching face can be enhanced.

A second embodiment of the present invention is an Mg-containing ZnO mixed single crystal laminate including a plurality of layers including an Mg-containing ZnO semiconductor having a bandgap (Eg) of $3.30 < Eg \leq 3.54$ eV, **characterized in that** the first layer is a growth layer having a film thickness of 5 $\mu$m or more. The number of the layers can be set to 2 or more. However, two layers are preferable in view of production efficiency. Since the above-mentioned ZnO-based mixed single crystal laminate has the first growth layer formed on the substrate and having the film thickness of 5 $\mu$m or more, the ZnO-based mixed single crystal laminate can relieve the diffusion of impurities from the substrate or the strain caused by the lattice mismatch between the substrate and the growth film. The bandgaps of the first and second growth layers can be optionally set. However, in consideration of electronic element application and optical element application, the bandgap of the first growth layer is preferably lower than that of the second growth layer.

In the preferable aspect of the present invention, at least one layer of the above-mentioned plurality of layers includes one or more selected from the group consisting of Al, Ga, In, H and F. The inclusion of one or more selected from the group consisting of Al, Ga, In, H and F can express electrical conductivity. If the substrate used in growth is removed by polishing and etching or the like, the electrodes can be formed on the front and rear surfaces of the electronic element or optical element in forming the electronic element or the optical element.

A third embodiment of the present invention is a method for producing an Mg-containing ZnO mixed single crystal by liquid phase epitaxial growth, **characterized in that** the method includes: mixing and melting ZnO and MgO as solutes and PbO and $Bi_2O_3$ as solvents; and putting a substrate into direct contact with the obtained melt solution, thereby growing the Mg-containing ZnO mixed single crystal on the substrate.

In the preferable aspect of the present invention, the mixing ratio of the solute with respect to PbO and $Bi_2O_3$ as the solvents is the solute expressed in terms of only ZnO:the solvent=5 to 30 mol%:95 to 70 mol%, and the mixing ratio of PbO and $Bi_2O_3$ as the solvents is PbO:$Bi_2O_3$=0.1 to 95 mol%:99.9 to 5 mol%. As the composition of the solvents, PbO:$Bi_2O_3$=30 to 90 mol%:70 to 10 mol% is more preferable, and particularly preferably PbO:$Bi_2O_3$=60 to 80 mol%:40 to 20 mol%. With PbO or $Bi_2O_3$ is independently used as the solvent, the temperature for liquid phase growth is high. Therefore, a PbO + $Bi_2O_3$ mixed solvent having the ratio as described above is preferable. As the mixing ratio of the solute expressed in terms of only ZnO and PbO and $Bi_2O_3$ as the solvents, more preferably, the concentration of the solute is 5 mol% or more and 10 mol% or less. When the concentration of the solute is less than 5 mol%, the growing rate is slow; whereas when the concentration of the solute is more than 10 mol%, the temperature for growth may be high.

A fourth embodiment of the present invention is a method for producing an Mg-containing ZnO mixed single crystal by liquid phase epitaxial growth, **characterized in that** the method includes: mixing and melting ZnO and MgO as solutes and $PbF_2$ and PbO as solvents; and putting a substrate into direct contact with the obtained melt solution, thereby growing the Mg-containing ZnO mixed single crystal on the substrate.

In the preferable aspect of the present invention, the mixing ratio of the solute with respect to $PbF_2$ and PbO as the solvents is the solute expressed in terms of only ZnO:the solvent=2 to 20 mol%:98 to 80 mol%, and the mixing ratio of $PbF_2$ and PbO as the solvents is $PbF_2$:PbO=80 to 20 mol%:20 to 80 mol%. When the mixing ratio of the solvents is $PbF_2$:PbO=80 to 20 mol%:20 to 80 mol%, the vaporizing amount of $PbF_2$ and PbO as the solvents can be suppressed. As a result, the variance in the concentration of the solute is reduced, and so the ZnO-based mixed single crystal can be stably grown. The mixing ratio of $PbF_2$ and PbO as the solvents is more preferably $PbF_2$:PbO=60 to 40 mol%:40 to 60 mol%. The mixing ratio of ZnO and MgO as the solutes and $PbF_2$ and PbO as the solvents is more preferable when the ratio of the solute expressed in terms of only ZnO is 5 to 10 mol%. When the concentration of the solute is less than 5 mol%, the effective growing rate is slow; whereas when the concentration of the solute is more than 10 mol%, the temperature for dissolving the solute components is high and thus the vaporizing amount of the solvents may be large.

A liquid phase growth technique is used in the third and fourth embodiments of the present invention. The liquid phase growth technique does not require a vacuum system unlike a vapor phase growth technique, and therefore, the liquid phase growth technique can produce the ZnO-based mixed single crystal at low cost. In addition, the liquid phase growth technique is thermal equilibrium growth, and therefore, the liquid phase growth technique can grow the ZnO-based mixed single crystal having high crystallinity. The liquid phase growth technique can control the degree of supersaturation to control a growth rate and achieve a relatively high growth rate.

In the preferable aspect of the present invention, the above-mentioned Mg-containing ZnO mixed single crystal includes a minute amount of other chemical elements. ZnO can express or change the characteristics thereof by being doped with other chemical elements. In the preferable aspect of the present invention, one or more selected from the group consisting of Li, Na, K, Cs, Rb, Be, Ca, Sr, Ba, Cu, Ag, N, P, As, Sb, Bi, B, Tl, Cl, Br, I, Mn, Fe, Co, Ni, Cd, Ti, Zr, Hf, V, Nb, Ta, Cr, Mo, W and lanthanoid elements is added. The amount thereof to be added is 20 mol% or less with respect to ZnO used as the solute, preferably 10 mol% or less, and more preferably 1 mol% or less. The other chemical elements is added, and therefore, ZnO becomes a p-type semiconductor, an n-type semiconductor or a magnetic semiconductor; the conductivity of ZnO is controlled; or ZnO is applied for a varistor or an electrical field light emitting element.

In the preferable aspect of the present invention, the ZnO single crystal is used as a substrate for growth. For a substrate for ZnO-based mixed crystal growth, any material which has the same type of crystalline structure as that of ZnO and does not react with the growing thin film can be used. Examples thereof include sapphire, $LiGaO_2$, $LiAlO_2$, $LiNbO_3$, $LiTaO_3$, $ScAlMgO_4$, GaN and ZnO. Considering that the target single crystal of the present invention is the ZnO-based mixed single crystal, however homo epitaxial growth using a ZnO substrate with which the lattice alignment between the substrate and the growth crystal is high is preferable in aspects of the crystallinity, reduction of strain, reduction of warpage of the growth film, and reduction in diffusion of impurities from the substrate.

In the preferable aspect of the present invention, the above-mentioned ZnO-based mixed single crystal is grown, and the substrate is then removed by polishing or etching. The diffusion of impurities from the substrate or the strain caused by the lattice mismatch can be relieved by removing the substrate. When the thickness of the first growth layer is 5 $\mu$m or more, the substrate may not be removed. The substrate may be removed after the first growth layer is grown or the second growth layer is grown.

A fifth embodiment of the present invention is a method for producing an Mg-containing ZnO mixed single crystal laminate, **characterized in that** the method includes: growing a first Mg-containing ZnO mixed single crystal by the method for producing the Mg-containing ZnO mixed single crystal described in the third or fourth embodiment; and further growing a second Mg-containing ZnO mixed single crystal on the first Mg-containing ZnO mixed single crystal used as a substrate. The bandgaps of the first growth layer and second growth layer can be optionally set. However, in consideration of electronic element application and optical element application, the bandgap of the first growth layer is preferably lower than that of the second growth layer. As a method for growing the laminate, LPE growth may be performed twice. For example, a plurality of melt solutions having different compositions may be prepared in a growth furnace and the laminate may be grown by moving a growth axis. Alternatively, the laminate can be also grown by using a sliding boat technique.

The Mg-containing ZnO mixed single crystal growth techniques in the present invention include liquid phase epitaxial growth (LPE technique), a flax technique, a top-seeded solution growth technique (TSSG technique), a solution growth technique, and a sliding boat technique. Particularly, in consideration of application to electronic elements and optical elements or the like, a liquid phase homo epitaxial growth technique using a ZnO substrate, with which a functionally distinct layer structure can be easily formed, is preferable.

In the third to fifth embodiments of the present invention, one or more third components may be added to the solvent in such a range that the ZnO solubility, the vaporizing amount of PbO and $Bi_2O_3$ or the vaporizing amount of $PbF_2$ and PbO is not significantly varied, for the purpose of controlling the temperature for liquid phase growth, adjusting the viscosity of the solvent and doping with a other chemical elements. Examples thereof include $B_2O_3$, $P_2O_5$ $V_2O_5$, $MoO_3$ $WO_3$, $SiO_2$ and BaO. $Bi_2O_3$ as the third components may be added to the solvent of the fourth embodiment of the present invention.

Examples

Hereinafter, as a method for growing an Mg-containing ZnO mixed single crystal according to an embodiment of the present invention, a method for growing the Mg-containing ZnO mixed single crystal on a ZnO substrate single crystal by liquid phase epitaxial growth will be described. The present invention is not limited by the following examples in any way.

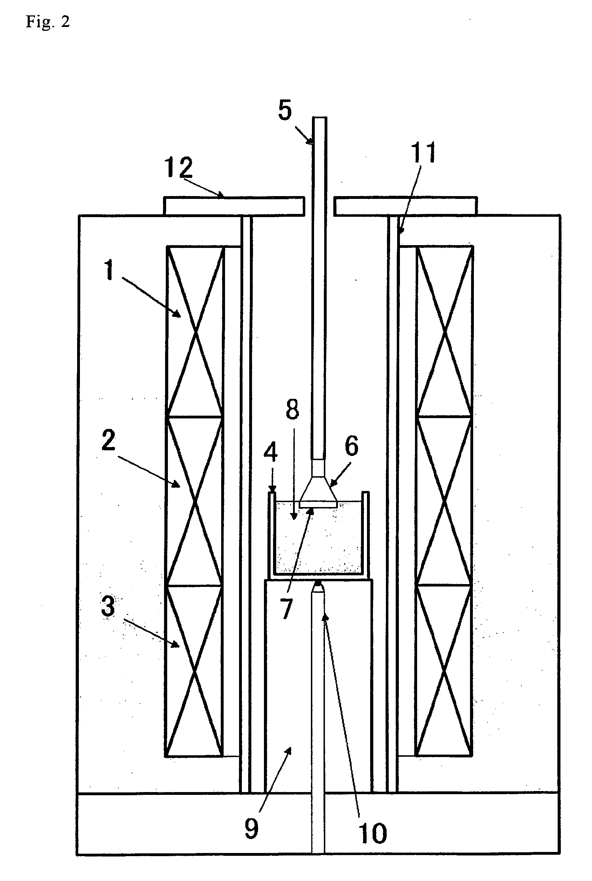

Figure 2 shows a structure of the furnace used here.

In the single crystal production furnace, a platinum crucible 4 for dissolving a material and accommodating the material as a melt solution is placed on a crucible table 9. Outer to, and to the side of, the platinum crucible 4, three stage side heaters (top heater 1, central heater 2, and bottom heater 3) for heating and dissolving the material in the platinum crucible 4 are provided. Outputs of the heaters are independently controlled, and the heating amounts of the heaters for the melt solution are independently adjusted. A furnace core tube 11 is provided between the heaters and the inner wall of the production furnace, and a furnace lid 12 for opening and closing the production furnace is provided above the furnace core tube 11. Above the platinum crucible 4, a lifting mechanism is provided. A lifting shaft 5 is fixed to the lifting mechanism, and a substrate holder 6 and a substrate 7 fixed by the holder are provided at a tip of the lifting shaft 5. Above the lifting shaft 5, a mechanism for rotating the lifting shaft 5 is provided. Below the platinum crucible 4, a thermocouple 10 for managing the temperature in the crucible is provided. The member of a growth furnace is preferably a non-Al-based material. As the non-Al-based material, a ZnO material is optimal. Considering that the ZnO material is not commercially available, MgO is preferable because MgO does not act as a carrier even if being mixed into the ZnO thin film. In consideration of the SIMS analysis results that the concentration of Si impurities in the LPE film is not increased even when a mullite material formed of alumina + silica is used, a quarts material is also preferable. Other usable materials include calcia, silica, $ZrO_2$, zircon ($ZrO_2$ + $SiO_2$) SiC, $Si_3N_4$ or the like.

From the above, an Mg-containing ZnO mixed single crystal (represented by a composition of $Zn_{1-x}Mg_xO$) is preferably grown by using a growth furnace formed of MgO and/or quarts as the non-Al-based material. In addition, the following embodiment is preferably used: the growth furnace includes a crucible table on which a crucible is allowed to be placed, a furnace core tube provided so as to surround an outer circumference of the crucible table, a furnace lid provided above the furnace core tube for opening and closing the furnace, and a lifting shaft for moving the seed crystal or substrate up and down; and these members are independently formed of MgO or quartz.

In order to dissolve the material in the platinum crucible, the temperature of the production furnace is increased to the temperature at which the material is dissolved. The temperature is preferably increased to 800 to 1100°C, and then the furnace is left still for 2 to 3 hours to stabilize the melt solution of the material. The standstill time may be shortened by stirring the solution using stirring blades made of Pt. At this point, the three stage heaters are offset such that the temperature at the bottom of the crucible is higher by several degrees than the temperature of the surface of the melt solution. Preferably, - 100°C ≤ H1 offset ≤ 0°C, 0°C ≤ H3 offset ≤ 100°C. More preferably, -50°C ≤ H1 offset ≤ 0°C, 0°C ≤ H3 offset ≤ 50°C. The bottom of the crucible is adjusted to have a seeding temperature of 700 to 950°C. After the temperature of the melt solution is stabilized, the lifting shaft is moved down while the substrate is rotated at 5 to 120 rpm, and thus the substrate is put into contact with the surface of the melt solution. After the substrate is properly coated with the melt solution, an Mg-containing ZnO mixed single crystal as the production target is grown on the substrate while the temperature is kept constant or is decreased at a rate of 0.025 to 1.0°C/hr. During the growth, the substrate is still rotated at 5 to 300 rpm by the rotation of the lifting shaft, and the rotation direction is reversed at a constant cycle. After the crystal is grown for about 30 minutes to 100 hours, the substrate is separated from the melt solution, and the lifting shaft is rotated at a high rate of about 200 to 300 rpm to separate the melt solution component. Then, the crystal is cooled down to room temperature over 1 to 24 hours. Thus, the Mg-containing ZnO mixed single crystal is obtained.

(Comparative Example 1)

According to the following process, a ZnO single crystal was produced by liquid phase epitaxial growth. Into a platinum crucible having an inner diameter of 75 mmφ, a height of 75 mmh and a thickness of 1 mm, ZnO, PbO and $Bi_2O_3$ as materials were put in respective amounts of 32.94 g, 800.61 g and 834.39 g. In this case, the concentration of ZnO as the solute is 7 mol%, and the concentration ratio of PbO:$Bi_2O_3$ as the solvents is 66.70 mol%:33.30 mol%. The crucible accommodating the materials was set in the furnace shown in Figure 2, and the temperature at the bottom of the crucible was kept at about 840°C for 1 hour. The materials were stirred and dissolved by a stirring pt tool. The materials were then cooled until the temperature at the bottom of the crucible became 785.8 °C. Then, a ZnO single crystal substrate grown by a hydrothermal technique and having a size of 10 mm x 10 mm x 0.5 mmt with a +(c) face direction was, as a seed crystal, put into contact with the melt solution, and the crystal was grown at this temperature for 24 hours while the lifting shaft was rotated at 30 rpm. In this step, the rotation direction of the shaft was reversed every 2 minutes. Then, the lifting shaft was lifted to be separated from the melt solution, and was rotated at 100 rpm to shake off the melt solution component. Thus, a colorless, transparent ZnO single crystal thin film was obtained. The growth rate was about 0.21 μm/hr. Table 1 shows the compounded amounts. Table 2 shows the LPE conditions and the characteristics of the obtained film.

The measured PL light emitting wavelength can be converted to bandgap energy by the following formula.

$$\text{Eg [eV]}=1.24/\text{PL light emitting wavelength [nm]}*1000$$

For the method for measuring the PL light emitting wavelength, rpm 2000 produced by Accent was used. The PL light emitting wavelength was measured at room temperature (300 K) using an He-Cd laser (λ= 325 nm) as an excitation laser.

(Examples 1 to 5)

The same technique as that of Comparative Example 1 was performed except that MgO as a solute was added to ZnO in compounded amounts shown in the following Table 1 to obtain Mg-containing ZnO mixed single crystal films. Table 1 shows the compounded amounts. Table 2 shows the LPE conditions and the characteristics of the obtained films.

Table 1 Compounded amounts of components used for producing ZnO single crystal and Mg-containing ZnO mixed single crystal

| | Feed (g) | | | | Feed (mol number) | | | | Composition of solute (mol%) | | Composition of solvent (mol%) | |
|---|---|---|---|---|---|---|---|---|---|---|---|---|
| | PbO | Bi2O3 | ZnO | MgO | PbO | Bi2O3 | ZnO | MgO | Concentration of solute expressed in terms of ZnO | MgO/(ZnO +MgO) | PbO | Bi2O3 |
| Com. Ex. 1 | 800.61 | 834.39 | 32.94 | 0.00 | 3.587 | 1.791 | 0.405 | 0 | 7.00 | 0.00 | 66.70 | 33.30 |
| Ex. 1 | 800.61 | 834.39 | 32.94 | 0.20 | 3:587 | 1.791 | 0.405 | 0.005 | 7.00 | 1.20 | 66.70 | 33.30 |
| Ex. 2 | 800.61 | 834.39 | 32.94 | 0.86 | 3.587 | 1.791 | 0.405 | 0.021 | 7.00 | 5.00 | 66.70 | 33.30 |
| Ex. 3 | 800.61 | 834.39 | 32.94 | 1.81 | 3.587 | 1.791 | 0.405 | 0.045 | 7.00 | 10.00 | 66.70 | 33.30 |
| Ex. 4 | 800.61 | 834.39 | 32.94 | 2.44 | 3.587 | 1.791 | 0.405 | 0.060 | 7.00 | 13.00 | 66.70 | 33.30 |
| Ex. 5 | 800.61 | 834.39 | 32.94 | 2.77 | 3.587 | 1.791 | 0.405 | 0.069 | 7.00 | 14.50 | 66.70 | 33.30 |
| Ex. 6 | 800.61 | 834.39 | 32.94 | 0.86 | 3.587 | 1.791 | 0.405 | 0.021 | 7.00 | 5.00 | 66.70 | 33.30 |
| Ex. 7 | 800.61 | 834.39 | 32.94 | 2.77 | 3.587 | 1.791 | 0.405 | 0.069 | 7.00 | 14.50 | 66.70 | 33.30 |

Table 2 Growth conditions of ZnO single crystal and Mg-containing ZnO mixed single crystal using PbO+Bi$_2$O$_3$ solvent and characteristics of obtained films

| | Substrate | Growth temperature | Growth time | Film thickness | Growth rate | PL light emitting | Rocking curve half value width | Lattice constant | | Conductivity | |
|---|---|---|---|---|---|---|---|---|---|---|---|
| | | | | | | eV | (002) face | c axis | a axis | Concentration of carrier | Mobility of carrier |
| | | °C | hr | μm | μm/hr | | arcsec | Å | Å | pieces/cm$^3$ | cm2/V·sec |
| Com. Ex. 1 | Hydrothermal synthesis substrate | 785.8 | 24 | 5.0 | 0.21 | 3.30 | 23 | 5.2054 | 3.2490 | 1.1E+17 | 82 |
| Ex. 1 | Hydrothermal synthesis substrate | 788.9 | 24 | 9.1 | 0.38 | 3.32 | 28 | 5.2047 | 3.2489 | 1.2E+17 | 114 |
| Ex. 2 | Hydrothermal synthesis substrate | 797.4 | 24 | 31.4 | 1.31 | 3.38 | 41 | 5.2023 | 3.2491 | 2.2E+17 | 106 |
| Ex. 3 | Hydrothermal synthesis substrate | 807.8 | 24 | 58.8 | 2.45 | 3.46 | 33 | 5.1996 | 3.2494 | 1.1E+17 | 90 |
| Ex. 4 | Hydrothermal synthesis substrate | 815.0 | 24 | 101.0 | 4.21 | 3.52 | 27 | 5.1984 | 3.2492 | 2.1E+17 | 68 |
| Ex. 5 | Hydrothermal synthesis substrate | 818.1 | 24 | 66.7 | 2.78 | 3.54 | 43 | 5.1973 | 3.2493 | 2.3E+17 | 52 |
| Ex. 6 | Hydrothermal synthesis substrate | 797.4 | 80 | 310.4 | 3.88 | 3.38 | 55 | 5.2022 | 3.2494 | 2.4E+17 | 101 |
| Ex. 7 | Ex. 6 growth film | 818.1 | 24 | 53.5 | 2.23 | 3.54 | 54 | 5.1975 | 3.2492 | 2.5E+17 | 50 |

The results obtained in Examples 1 to 5 show that the Mg-containing ZnO mixed single crystal film having the film thickness of 5 $\mu$m or more and having the bandgap (Eg) of 3.30 < Eg $\leq$ 3.54 eV can be produced using the LPE technique. It is not preferable that an MgO single phase other than the ZnO-based mixed crystal is deposited when the bandgap (Eg) is more than 3.54 eV. The results show that the Mg-containing ZnO mixed single crystal film has the (002) face having the rocking curve half value width of 28 to 55 arcsec and has high crystallinity which is about the same as that of the hydrothermal synthesis substrate (20 to 30 arcsec). The lattice constant of the c axis of the Mg-containing ZnO mixed single crystal film decreases to the rising of the bandgap, whereas the lattice constant of the a axis varies little. This shows that the Mg-containing ZnO mixed single crystal film can be grown with the lattice alignment of the ZnO substrate mostly held.

The above results show that the Mg-containing ZnO mixed single crystal having the thickness of 5 $\mu$m or more can be produced on the substrate by the liquid phase epitaxial growth by mixing and melting ZnO and MgO as the solutes and PbO and $Bi_2O_3$ as the solvents and then directly putting the substrate into direct contact with the obtained melt solution. The Mg-containing ZnO mixed single crystal obtained in the present invention has high crystallinity, low electron-releasing impurities as observed by concentration of carrier, and high mobility of carrier. The Mg-containing ZnO mixed single crystal film of the present invention has a high growth rate of 0.38 to 4.21 $\mu$m /hr, and the Mg-containing ZnO mixed single crystal film having the thickness of 5 $\mu$m or more can be easily grown. Since the bandgap (Eg) can be controlled within a range of 3.30 < Eg $\leq$ 3.54 eV by changing the MgO composition to ZnO and the growth film thickness can be set to 5 $\mu$m or more, the diffusion of impurities from the substrate or the strain caused by the lattice mismatch can be relieved. Therefore, the Mg-containing ZnO mixed single crystal film can be expected to be used for electronic elements and optical elements, which are expected to be developed in the future.

(Example 6)

The same materials as those of Example 2 were used. The setting temperature of an LPE furnace was cooled at a rate of -0.1°C/hr during LPE growth, and the growth time was set to 80 hr to obtain an Mg-containing ZnO mixed single crystal having a thickness of about 310 $\mu$m. Table 2 shows the LPE conditions and the characteristics of the obtained film. The film characteristics of Example 6 were almost the same as those of Example 4 having the same composition. The used substrate was removed by grinding and polishing to obtain a self-standing substrate of an Mg-containing ZnO mixed single crystal having a thickness of about 280 $\mu$m.

(Example 7)

An Mg-containing ZnO mixed single crystal laminate was obtained by the same technique as that of Example 5 except that the self-standing substrate obtained in Example 6 was used as the substrate. Table 2 shows the LPE conditions and the characteristics of the obtained film. If the self-standing substrate obtained in Example 6 is defined as the first growth layer, the bandgap ratio of the first growth layer/the second growth layer is 3.38 eV/3.54 eV.

(Comparative Example 2)

According to the following process, a ZnO single crystal was produced by liquid phase epitaxial growth. Into a platinum crucible having an inner diameter of 75 mm$\phi$, a height of 75 mmh and a thickness of 1 mm, ZnO, $PbF_2$ and PbO as materials were put in respective amounts of 32.94 g, 942.93 g and 858.34 g. In this case, the concentration of ZnO as the solute is about 5 mol%, and the concentration ratio of $PbF_2$:PbO as the solvents is 50.0 mol%:50.0 mol%. The crucible accommodating the materials was set in the furnace shown in Figure 2, and the materials were dissolved with the temperature at the bottom of the crucible being about 940°C. The materials were then kept at this temperature for 3 hours and then cooled until the temperature at the bottom of the crucible became 835°C. Then, a ZnO single crystal substrate grown by a hydrothermal technique and having a size of 10 mm x 10 mm x 0.5 mmt with a +(c) face direction was, as a seed crystal, put into contact with the melt solution, and the crystal was grown at this temperature for 6 hours while the lifting shaft was rotated at 60 rpm. In this case, the rotation direction of the shaft was reversed every 5 minutes. Then, the alumina lifting shaft was lifted to be separated from the melt solution, and was rotated at 200 rpm to shake off the melt solution component. Thus, a colorless, transparent ZnO single crystal thin film was obtained. In this case, the growth rate was about 0.18 $\mu$m/hr. Table 3 shows the compounded amounts. Table 4 shows the LPE conditions and the characteristics of the obtained film. The half width of the rocking curve was about 31 arcsec, which shows good crystallinity.

(Examples 8 to 11)

The same method as that of Comparative Example 2 was performed except that MgO as the solute was added to ZnO in compounded amounts shown in the following Table 3 to obtain an Mg-containing ZnO mixed single crystal film. Table 3 shows the compounded amounts. Table 4 shows the LPE conditions and the characteristics of the obtained films.

Table 3 Compounded amounts of components used for producing ZnO single crystal and Mg-containing ZnO mixed single crystal

| | Feed (g) | | | | Feed (mol number) | | | | Composition of solute (mol%) | | Composition of solvent (mol%) | |
|---|---|---|---|---|---|---|---|---|---|---|---|---|
| | PbO | PbF2 | ZnO | MgO | PbO | PbF2 | ZnO | MgO | Concentration of solute expressed in terms of ZnO | MgO/(ZnO+ MgO) | PbO | PbF2 |
| Com. Ex. 2 | 858.34 | 942.93 | 32.94 | 0.00 | 3.846 | 3.846 | 0.405 | 0.000 | 5.00 | 0.00 | 50.00 | 50.00 |
| Ex. 8 | 858.34 | 942.93 | 32.94 | 0.86 | 3.846 | 3.846 | 0.405 | 0.021 | 5.00 | 5.00 | 50.00 | 50.00 |
| Ex. 9 | 858.34 | 942.93 | 32.94 | 1.81 | 3.846 | 3.846 | 0.405 | 0.045 | 5.00 | 10.00 | 50.00 | 50.00 |
| Ex. 10 | 858.34 | 942.93 | 32.94 | 2.44 | 3.846 | 3.846 | 0.405 | 0.060 | 5.00 | 13.00 | 50.00 | 50.00 |
| Ex. 11 | 858.34 | 942.93 | 32.94 | 2.77 | 3.846 | 3.846 | 0.405 | 0.069 | 5.00 | 14.50 | 50.00 | 50.00 |

Table 4 Growth conditions of ZnO single crystal and Mg-containing ZnO mixed single crystal using $PbF_2$+PbO solvent and characteristics of obtained films

| | Substrate | Growth temperature | Growth time | Film thickness | Growth rate | PL light emitting | Rocking curve half value width | Lattice constant | | Conductivity | |
|---|---|---|---|---|---|---|---|---|---|---|---|
| | | | | | | eV | (002) face | c axis | a axis | Concentration of carrier | Mobility of carrier |
| | | °C | hr | $\mu$m | $\mu$m/hr | | arcsec | Å | Å | pieces/cm$^3$ | cm2/V·sec |
| Com. Ex. 2 | Hydrothermal synthesis substrate | 835.0 | 6 | 108 | 18.00 | 3.30 | 31 | 5.2053 | 3.2492 | 2.3E+17 | 103 |
| Ex. 8 | Hydrothermal synthesis substrate | 846.0 | 24 | 52.8 | 2.20 | 3.38 | 31 | 5.2026 | 3.2490 | 3.1E+17 | 98 |
| Ex. 9 | Hydrothermal synthesis substrate | 856.5 | 24 | 77.8 | 3.24 | 3.48 | 28 | 5.1993 | 3.2489 | 2.7E+17 | 85 |
| Ex. 10 | Hydrothermal synthesis substrate | 863.9 | 24 | 26.4 | 1.10 | 3.52 | 36 | 5.1984 | 3.2992 | 3.8E+17 | 65 |
| Ex. 11 | Hydrothermal synthesis substrate | 867.0 | 24 | 8.4 | 0.35 | 3.54 | 42 | 5.1945 | 3.2493 | 4.1E+17 | 59 |

The results of Examples 8 to 11 show that the present invention can produce an Mg-containing ZnO mixed single crystal film having a bandgap (Eg) of 3.30 < Eg ≤ 3.54 eV, the Mg-containing ZnO mixed single crystal film having a film thickness of 5 $\mu$m or more using the LPE technique. The results show that the Mg-containing ZnO mixed single crystal film has the (002) face having the rocking curve half value width of 28 to 42 arcsec and has high crystallinity which is about the same as that of the hydrothermal synthesis substrate (20 to 30 arcsec). The lattice constant of the c axis of the Mg-containing ZnO mixed single crystal film decreases to the rising of the bandgap, whereas the lattice constant of the a axis varies little. This shows that the Mg-containing ZnO mixed single crystal film can be grown with the lattice alignment of the ZnO substrate mostly held.

The above results show that the Mg-containing ZnO mixed single crystal having the thickness of 5 $\mu$m or more can be produced on the substrate by the liquid phase epitaxial growth by mixing and melting ZnO and MgO as the solutes and PbO and $PbF_2$ as the solvents and then directly putting the substrate into direct contact with the obtained melt solution. The Mg-containing ZnO mixed single crystal obtained in the present invention has high crystallinity, low electron-releasing impurities as observed by concentration of carrier, and high mobility of carrier. The Mg-containing ZnO mixed single crystal film of the present invention has a high growth rate of 0.35 to 2.20 $\mu$m /hr, and the Mg-containing ZnO mixed single crystal film having the thickness of 5 $\mu$m or more can be easily grown. Since the bandgap (Eg) can be controlled within a range of 3.30 < Eg ≤ 3.54 eV by changing the MgO composition to ZnO and the growth film thickness can be set to 5 $\mu$m or more, the diffusion of impurities from the substrate or the strain caused by the lattice mismatch can be relieved. Therefore, the Mg-containing ZnO mixed single crystal film can be expected to be used for electronic elements and optical elements, which are expected to be developed in the future.

When $PbO+Bi_2O_3$ is compared with $PbO+PbF_2$ as growth solvents for the Mg-containing ZnO ($Zn_{1-x}Mg_xO$) mixed single crystal film, the solvent of $PbO+PbF_2$ tends to have higher carrier density and lower mobility of carrier than those of the solvent of $PbO+Bi_2O$. It is believed that when $PbF_2$ is used, F is taken in into the $Zn_{1-x}Mg_xO$ mixed crystal film, thereby increasing the carrier density to drop the mobility of carrier.

(Examples 12 and 13)

An Mg-containing ZnO mixed single crystal to which Al was added was obtained by using the same technique as that of Example 2 except that $Al_2O_3$ was added. Table 5 shows the compounded amounts. Table 6 shows the LPE conditions and the characteristics of the obtained films.

Table 5 Compounded amounts of components used for producing Mg-containing ZnO mixed single crystal to which Al is added

| | Feed (g) | | | | | Feed (mol number) | | | | | Composition of solute (mol% | | |
|---|---|---|---|---|---|---|---|---|---|---|---|---|---|
| | PbO | Bi2O3 | ZnO | MgO | Al2O3 | PbO | Bi2O3 | ZnO | MgO | Al2O3 | Concentration of solute expressed in terms of ZnO | MgO/(ZnO +MgO) | Al2O3/(Al2O3+ ZnO) |
| Ex. 2 | 800.61 | 834.39 | 32.94 | 0.86 | 0 | 3.587 | 1.791 | 0.405 | 0.021 | 0.00 | 7.00 | 5.00 | 0 |
| Ex. 12 | 800.61 | 834.39 | 32.94 | 0.86 | 0.003 | 3.587 | 1.791 | 0.405 | 0.021 | 2.9E-05 | 7.00 | 5.00 | 7.3E-05 |
| Ex. 13 | 800.61 | 834.39 | 32.94 | 0.86 | 0.030 | 3.587 | 1.791 | 0.405 | 0.021 | 2.9E-04 | 7.00 | 5.00 | 7.3E-04 |

Table 6 Growth conditions of Mg-containing ZnO mixed single crystal to which Al is added and characteristics of obtained films

| | Growth substrate | Growth temperature | Growth time | Film thickness | Growth rate | PL light emitting | Rocking curve half value width | Lattice constant | | Conductivity | |
|---|---|---|---|---|---|---|---|---|---|---|---|
| | | | | | | eV | (002) face | c axis | a axis | Concentration of carrier | Mobility of carrier |
| | | °C | hr | μm | μm/hr | | arcsec | Å | Å | pieces/cm$^3$ | cm2/V·sec |
| Ex. 2 | Hydrothermal synthesis substrate | 797.4 | 24 | 31.4 | 1.31 | 3.39 | 41 | 5.2023 | 3.2491 | 2.2E+17 | 106 |
| Ex. 12 | Hydrothermal synthesis substrate | 797.1 | 24 | 38.2 | 1.59 | 3.38 | 38 | 5.2024 | 3.2490 | 1.4E+18 | 55 |
| Ex. 13 | Hydrothermal synthesis substrate | 796.4 | 24 | 71.5 | 2.98 | 3.40 | 45 | 5.2026 | 3.2494 | 1.6E+19 | 40 |

The results obtained in Examples 12 to 13 show that the Mg-containing ZnO mixed single crystal film to which Al is added can be obtained by using the LPE technique, the Mg-containing ZnO mixed single crystal film having the film thickness of 5 $\mu$m or more and having the bandgap (Eg) of 3.38 to 3.40 eV. The results show that the Mg-containing ZnO mixed single crystal film has the (002) face having the rocking curve half value width of 38 to 45 arcsec and has high crystallinity which is about the same as that of the hydrothermal synthesis substrate (20 to 30 arcsec). The lattice constant of the Mg-containing ZnO mixed single crystal film to which Al was added was about the same as that of the Mg-containing ZnO mixed single crystal film to which Al was not added. On the other hand, the concentration of carrier increased as the amount of Al to be added increased, and the mobility of carrier dropped.

The above results show that the concentration of carrier can be controlled by adding electron-releasing impurities such as Al when the Mg-containing ZnO mixed single crystal is subjected to liquid phase epitaxial growth. The Mg-containing ZnO mixed single crystal to which Al is added according to the present invention has high crystallinity, and can control the carrier while highly holding the mobility of carrier. Since the growth film thickness can be set to 5 $\mu$m or more, the diffusion of impurities from the substrate or the strain caused by the lattice mismatch can be relieved. Therefore, the Mg-containing ZnO mixed single crystal can be expected to be used for electronic elements and optical elements, which are expected to be developed in the future.

**Claims**

1. An Mg-containing ZnO mixed single crystal, wherein the mixed single crystal comprises an Mg-containing ZnO semiconductor having a bandgap (Eg) of 3.30 < Eg ≤ 3.54 eV, and has a film thickness of 5 $\mu$m or more.

2. The Mg-containing ZnO mixed single crystal according to claim 1, further comprising one or more selected from the group consisting of Al, Ga, In, H and F.

3. The Mg-containing ZnO mixed single crystal according to claim 1 or 2, wherein the growth direction is a +(c) face direction.

4. An Mg-containing ZnO mixed single crystal laminate comprising a plurality of layers including an Mg-containing ZnO semiconductor having a bandgap (Eg) of 3.30 < Eg ≤ 3.54 eV, wherein the first layer is a growth layer having a film thickness of 5 $\mu$m or more.

5. The Mg-containing ZnO mixed single crystal laminate according to claim 4, wherein at least one layer of the plurality of layers contains one or more selected from the group consisting of Al, Ga, In, H and F.

6. The Mg-containing ZnO mixed single crystal laminate according to claim 4 or 5, wherein the growth direction is a + (c) face direction.

7. A method for producing an Mg-containing ZnO mixed single crystal by liquid phase epitaxial growth, comprising the steps of:

   mixing and melting ZnO and MgO as solutes and PbO and $Bi_2O_3$ as solvents; and
   putting a substrate into direct contact with the obtained melt solution, thereby growing the Mg-containing ZnO mixed single crystal on the substrate.

8. The method for producing the Mg-containing ZnO mixed single crystal according to claim 7, wherein the mixing ratio of the solute to the solvent is 5 to 30 mol%:95 to 70 mol% when the solute is expressed in terms of only ZnO, and the mixing ratio of PbO and $Bi_2O_3$ as the solvents is 0.1 to 95 mol%:99.9 to 5 mol%.

9. A method for producing an Mg-containing ZnO mixed single crystal by liquid phase epitaxial growth, comprising the steps of:

   mixing and melting ZnO and MgO as solutes and $PbF_2$ and PbO as solvents; and
   putting a substrate into direct contact with the obtained melt solution, thereby growing the Mg-containing ZnO mixed single crystal on the substrate.

10. The method for producing the Mg-containing ZnO mixed single crystal according to claim 9, wherein the mixing ratio of the solute to the solvent is 2 to 20 mol%:98 to 80 mol% when the solute is expressed in terms of only ZnO, and the mixing ratio of PbF$_2$ and PbO as the solvents is 80 to 20 mol%:20 to 80 mol%.

11. The method for producing the Mg-containing ZnO mixed single crystal according to any one of claims 7 to 10, wherein the Mg-containing ZnO mixed single crystal comprises a minute amount of other chemical elements.

12. The method for producing the Mg-containing ZnO mixed single crystal according to claim 11, wherein the minute amount of other chemical elements is 1 mol% or less of other chemical elements.

13. The method for producing the Mg-containing ZnO mixed single crystal according to claim 11 or 12, wherein the other chemical elements is one or more selected from the group consisting of Li, Na, K, Cs, Rb, Be, Ca, Sr, Ba, Cu, Ag, N, P, As, Sb, Bi, B, Tl, Cl, Br, I, Mn, Fe, Co, Ni, Ti, Cd, Zr, Hf, V, Nb, Ta, Cr, Mo, W and lanthanoid elements.

14. The method for producing the Mg-containing ZnO mixed single crystal according to any one of claims 7 to 13, wherein a ZnO single crystal is used as the substrate.

15. The method for producing the Mg-containing ZnO mixed single crystal according to any one of claims 7 to 13, comprising removing the substrate by polishing or etching after the Mg-containing ZnO mixed single crystal is grown.

16. A method for producing an Mg-containing ZnO mixed single crystal laminate, comprising the steps of:

growing a first Mg-containing ZnO mixed single crystal by the method for producing the Mg-containing ZnO mixed single crystal according to any one of claims 7 to 13; and
further growing a second Mg-containing ZnO mixed single crystal on the first Mg-containing ZnO mixed single crystal used as a substrate.

ZnO-based mixed single crystal having electrical conductivity

p+ layer

p layer

Light emitting layer

n layer

n+ layer

Electrode

Element structure of the present invention

p+ layer

p layer

Light emitting layer

n layer

n+ layer

Insulative substrate

Electrode

Conventional element structure

Fig. 1

20

Fig. 2

## INTERNATIONAL SEARCH REPORT

| | International application No. |
|---|---|
| | PCT/JP2008/055179 |

**A. CLASSIFICATION OF SUBJECT MATTER**
C30B29/22(2006.01)i, C30B19/02(2006.01)i, H01L21/368(2006.01)i, H01L33/00 (2006.01)i

According to International Patent Classification (IPC) or to both national classification and IPC

**B. FIELDS SEARCHED**

Minimum documentation searched (classification system followed by classification symbols)
C30B29/22, C30B19/02, H01L21/368, H01L33/00

Documentation searched other than minimum documentation to the extent that such documents are included in the fields searched
Jitsuyo Shinan Koho          1922-1996    Jitsuyo Shinan Toroku Koho    1996-2008
Kokai Jitsuyo Shinan Koho    1971-2008    Toroku Jitsuyo Shinan Koho    1994-2008

Electronic data base consulted during the international search (name of data base and, where practicable, search terms used)
Science Direct, JSTPlus(JDreamII), Science Citation Index Expanded (Web of Science)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | H. SATO et al., Growth of $Mg_xZn_{1-x}O$/ZnO heterostructures by liquid phase epitaxy, Japanese Journal of Applied Physics, 2006, Vol. 45, No. 1A, pp.190-193 | 1,3,4,6<br>2,5<br>7-16 |
| Y<br>A | JP 2002-093822 A (National Institute of Advanced Industrial Science and Technology), 29 March, 2002 (29.03.02), Par. Nos. [0022] to [0024] & US 2002/0058351 A1 | 2,5<br>1,3,4,6-16 |
| A | K. FISCHER et al., On the preparation of ZnO single crystals, Crystal Reseach and Technology, 1981, Vol. 16, No. 6, p.689-694 | 1-16 |

| ☒ | Further documents are listed in the continuation of Box C. | ☐ | See patent family annex. |
|---|---|---|---|

\* Special categories of cited documents:
"A" document defining the general state of the art which is not considered   to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>16 April, 2008 (16.04.08) | Date of mailing of the international search report<br>01 May, 2008 (01.05.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2008/055179 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | N. B. CHEN et al., Recent progress in research on $Mg_xZn_{1-x}O$ alloys, Materials Science & Engineering B, 2006, Vol. 126, p.16-21 | 1-16 |
| P,A | WO 2007/100146 A1  (Mitsubishi Gas Chemical Co., Inc.), 07 September, 2007 (07.09.07), Full text (Family: none) | 1-16 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005072067 A
- JP 2003046081 A

**Non-patent literature cited in the description**

- **A. Ohtomo.** *Applied Physics Letters,* 11 May 1998, vol. 72 (19), 2466-2468
- **Maki et al.** *Jpn. J. Appl. Phys.,* 2003, vol. 42, 75-77